# EUROPEAN PATENT SPECIFICATION

(11) **EP 3 226 314 B1**
(45) Date of publication and mention of the grant of the patent: **08.08.2018**
(21) Application number: 17153473.8
(22) Date of filing: 27.01.2017
(51) Int. Cl.: H01L 35/08

(54) **THERMOELECTRIC CONVERSION MODULE COMPRISING STRESS RELAXATION STRUCTURE**
MODUL ZUR THERMOELEKTRISCHEN UMWANDLUNG MIT SPANNUNGSABBAUSTRUKTUR
MODULE DE CONVERSION THERMOÉLECTRIQUE AVEC STRUCTURE DE RELAXATION DE CONTRAINTE

(30) Priority: 31.03.2016 JP 2016070137
(43) Date of publication of application: 04.10.2017
(73) Proprietor: Hitachi Metals, Ltd., Tokyo 108-8224 (JP)
(72) Inventor: YASUDA, Yusuke, Tokyo, 100-8280 (JP); NISHIDE, Akinori, Tokyo, 100-8280 (JP); MIYAUCHI, Akihiro, Tokyo, 100-8280 (JP); KUBOTA, Chiemi, Tokyo, 100-8280 (JP); FUJIWARA, Shinichi, Tokyo, 100-8280 (JP); SHIMADA, Takeshi, Tokyo, 108-8224 (JP); YAMAURA, Hideki, Tokyo, 108-8224 (JP); FUKATANI, Naoto, Tokyo, 100-8280 (JP)
(74) Representative: MERH-IP Matias Erny Reichl Hoffmann Patentanwälte PartG mbB

(56) References cited:
- EP-A2- 0 432 867
- JP-A- S55 117 249
- JP-A- 2003 229 609
- JP-A- 2008 010 764
- US-A1- 2012 097 206
- US-A1- 2014 174 706
- US-A1- 2014 261 607

## Description

### Technical Field

The present invention relates to a stress relaxation structure and a thermoelectric conversion module.

### Background Art

Conventionally, a thermal conductive stress relaxation structure that has excellent conductivity of heat from a high-temperature substance to a low-temperature substance as well as excellent thermal stress relaxation ability has been known (see Patent Literature 1 below). Patent Literature 1 discloses a structure that be produced relatively easily and can achieve both high thermal conductivity and high thermal stress relaxation ability in view of the necessity of implementing efficient thermal conduction to allow heat-generating devices or machines to be stably operated and the importance of reducing or relaxing a thermal stress to enhance the durability and reliability of the devices or machines.

In addition, an invention of a bonding body, a semiconductor device using the bonding body, and a method for producing them are known (see Patent Literature 2 below). Patent Literature 2 discloses a bonding body that can relax a stress and reduce electrical resistance as well as thermal resistance in view of the problem that a connection member that is formed by solder printing and reflow and the like cannot obtain a densely arranged array, and has high electrical resistance and high thermal resistance.

### Citation List

### Patent Literature

Patent Literature 1: JP 2014-143400 A
Patent Literature 2: JP 2014-183256 A
Patent Literature 3: EP 0 432 867 A2
Patent Literature 4: JP 2003-229609A

### Summary of Invention

### Technical Problem

For example, in a thermoelectric conversion module used to recover energy from waste heat and a semiconductor device used for an inverter or the like, a heat cycle is generated in which a high temperature condition and a low temperature condition are repeated for a long period. In order to stably operate a device or machine that is subjected to such a heat cycle, it is necessary to increase the efficiency of heat transfer from the high temperature side to the low temperature side. In addition, as a thermal stress is generated in each member that constitutes the device or machine due to the difference in the coefficient of thermal expansion, it is important to relax the thermal stress between each member in order to ensure the long-term reliability.

As a stress relaxation structure to that end, a structure obtained by rolling up a thermally conductive ribbon or sheet has been conventionally used. This is because using such a stress relaxation structure has the effects of absorbing strains that are generated between each member and thus relaxing a thermal stress.

For example, the thermal conductive stress relaxation structure described in Patent Literature 1 above has an assembly configured such that a thermal conductive material gathers in a non-bonded state. The assembly is a rolled-up body obtained by alternately rolling up a carbon-based sheet material and a metal-based sheet material, for example (see the claims). Such a structure achieves both high thermal conductivity and high thermal stress relaxation ability by using a carbon-based sheet material and a metal-based sheet material for the rolled-up body. However, the carbon-based sheet material is inferior in the bonding property with respect to a member that is bonded to the structure, and thus has a possibility of decreasing the bonding reliability of the structure and reducing the vibration durability.

The semiconductor device described in Patent Literature 2 above has a rolled-up portion and a stress relaxation portion as a bonding body that bonds a first member and a second member together in an electrically conductive manner and a thermally conductive manner, and the rolled-up portion is formed by rolling up a belt-like foil object with high electrical conductivity and high thermal conductivity, such as aluminum (for example, see claim 1 and paragraphs 0012 to 0017). However, when the rolled-up portion is made of only ordinary metal foil, there is a possibility that the thermal stress relaxation ability of the bonding body may be low. Patent Literature 3 describes a heat-conductive composite material usable as a substrate for mounting a semiconductor thereon or a lead frame, which comprises a core sheet and metal foil layers welded to the both surfaces of the core sheet. In Patent Literature 4 is described that a plurality of graphite materials are arranged in a plane type in such a manner that sliced surfaces are turned into sheet surfaces of the relaxation material.

It is an object of the present invention to provide a thermoelectric conversion module with a stress relaxation structure that can achieve both high thermal conductivity and high thermal stress relaxation ability and has excellent vibration durability.

### Solution to Problem

The aforementioned object is solved by the invention according to the independent claim 1. Further preferred developments are described by the dependent claims.

### Advantageous Effects of Invention

According to the present invention, there can be provided a thermoelectric conversion module with a stress relaxation structure that can achieve both high thermal conductivity and high thermal stress relaxation ability and has excellent vibration durability.

### Brief Description of Drawings

FIG. 1 is a schematic perspective view of a stress relaxation structure in accordance with an embodiment of the present invention.
FIG. 2 is a schematic cross-sectional view of a stress relaxation structure along a line II-II shown in FIG. 1.
FIG. 3 is a schematic view illustrating an example of a method for producing the stress relaxation structure shown in FIG. 1.
FIG. 4 is a schematic view illustrating an example of a method for producing the stress relaxation structure shown in FIG. 1.
FIG. 5 is a schematic cross-sectional view of a thermoelectric conversion module in accordance with an embodiment of the present invention.
FIG. 6A is a schematic cross-sectional view illustrating a method for producing the thermoelectric conversion module shown in FIG. 5.
FIG. 6B is a schematic cross-sectional view illustrating a method for producing the thermoelectric conversion module shown in FIG. 5.
FIG. 6C is a schematic cross-sectional view illustrating a method for producing the thermoelectric conversion module shown in FIG. 5.
FIG. 6D is a schematic cross-sectional view illustrating a method for producing the thermoelectric conversion module shown in FIG. 5.
FIG. 6E is a schematic cross-sectional view illustrating a method for producing the thermoelectric conversion module shown in FIG. 5.
FIG. 6F is a schematic cross-sectional view illustrating a method for producing the thermoelectric conversion module shown in FIG. 5.
FIG. 7 is a schematic cross-sectional view of an insulating substrate that uses the stress relaxation structure shown in FIG. 1.
FIG. 8 is a graph showing the relationship between the initial bonding strength of a stress relaxation structure of an example and that of a comparative example.

### Description of Embodiments

Hereinafter, embodiments of a stress relaxation structure of the present invention will be described in detail with reference to the drawings.

### [Stress relaxation structure]

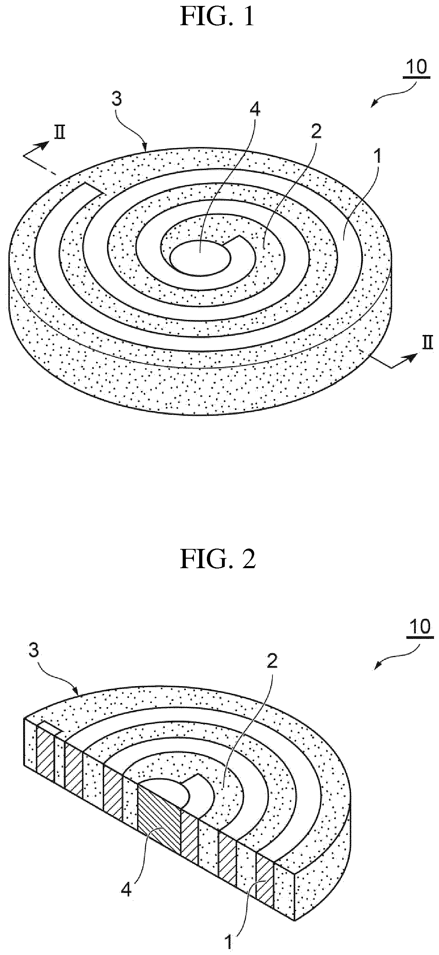

FIG. 1 is a schematic perspective view of a stress relaxation structure 10 in accordance with an embodiment of the present invention. FIG. 2 is a schematic cross-sectional view of the stress relaxation structure 10 along a line II-II shown in FIG. 1.

The stress relaxation structure 10 in this embodiment has a rolled-up body 3 obtained by alternately rolling up a first thermal conductor 1 and a second thermal conductor 2. The first thermal conductor 1 is metal foil and the second thermal conductor 2 is porous metal foil. Additionally, the stress relaxation structure 10 may have the first thermal conductor 1 and the second thermal conductor 2, which are bonded together, of the rolled-up body 3.

The materials of the metal foil of the first thermal conductor 1 and the porous metal foil of the second thermal conductor 2 are not particularly limited as long as they are metal with excellent thermal conductivity. For example, copper or nickel can be used, and copper with higher thermal conductivity is preferably used. The metal foil of the first thermal conductor 1 and the porous metal foil of the second thermal conductor 2 may be formed of either a single material or a combination of two or more materials with different qualities or properties, but are preferably a belt-like continuous body.

For the porous metal foil of the second thermal conductor 2, a porous film formed by electroless copper plating described on pages 66-69 of the Journal of The Japan Institute of Electronics Packaging, Vol. 1 (1998), No. 1 can be used, for example.

In the stress relaxation structure 10 in this embodiment, the rolled-up body 3 has a core material 4 in the center. The first thermal conductor 1 and the second thermal conductor 2 are alternately rolled up around the core material 4. Although the core material 4 has a columnar shape in the example shown in FIGS. 1 and 2, the shape of the core material 4 is not limited thereto. For example, the core material 4 may have a plate shape, a polygonal columnar shape, or a cylindrical shape. The material of the core material 4 is not particularly limited as long as it is a material with excellent thermal conductivity and heat resistance. For example, a metal material or an inorganic material can be used. Providing the stress relaxation structure 10 with the core material 4 has the effect of being able to easily rolling up the first thermal conductor 1 and the second thermal conductor 2. It should be noted that the stress relaxation structure 10 need not necessarily have the core material 4 as long as the first thermal conductor 1 and the second thermal conductor 2 can be rolled up.

In the stress relaxation structure 10 in this embodiment, both the first thermal conductor 1, which is metal foil, and the second thermal conductor 2, which is porous metal foil, are exposed at the end faces of the rolled-up body 3 in the roll-up axis direction, that is, the core material 4 in the axial direction.

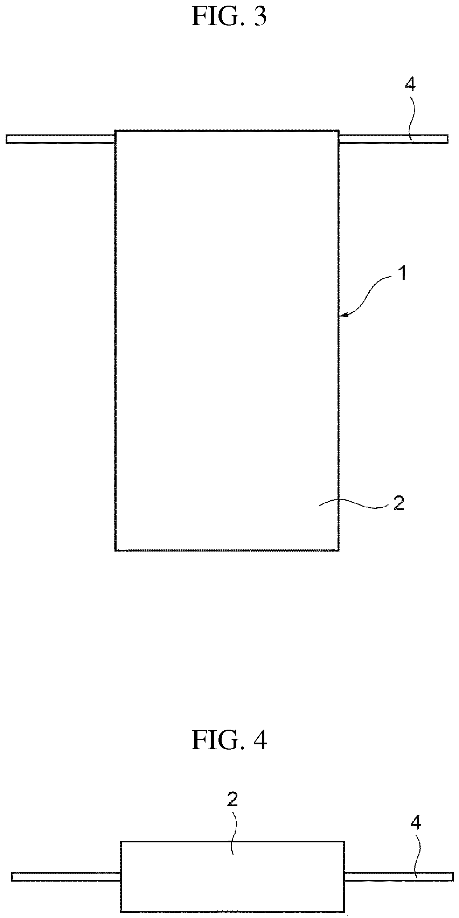

Hereinafter, an example of a method for producing the stress relaxation structure 10 in this embodiment will be described. FIGS. 3 and 4 are schematic views each illustrating an example of a method for producing the stress relaxation structure 10 in this embodiment.

In order to produce the stress relaxation structure 10, first, porous metal foil that is the second thermal conductor 2 is formed continuously on the surface of metal foil that is the first thermal conductor 1, in the roll-up direction. More specifically, copper foil is prepared as the metal foil of the first thermal conductor 1, for example, and porous metal foil, which is made of a porous film, is formed on the surface of the copper foil by the aforementioned electroless copper plating. Accordingly, the porous metal foil that is the second thermal conductor 2 is formed on the surface of the metal foil that is the first thermal conductor 1. With the second thermal conductor formed by the plating, strains that occur between each member can be absorbed, and a thermal stress can thus be relaxed.

Next, as shown in FIG. 3, the core material 4 is prepared, and an end of the first thermal conductor 1, which has the second thermal conductor 2 bonded thereto, in the longitudinal direction is fixed to the core material 4. More specifically, a copper bar is prepared as the core material 4, and an end of the first thermal conductor 1, which has the second thermal conductor 2 bonded thereto, in the longitudinal direction is bonded to the copper bar by laser welding, resistance welding, low-temperature-sintering metal bonding, solder bonding, or resin bonding.

Next, the first thermal conductor 1 and the second thermal conductor 2 that are fixed to the core material 4 are rolled up around the core material 4 as shown in FIG. 4, and the terminal end portions of the first thermal conductor 1 and the second thermal conductor 2 are fixed. More specifically, for example, the first thermal conductor 1 and the second thermal conductor 2 are rolled up around the core material 4 until the outside diameter reaches about 5 mm, and a copper oxide paste to obtain a sintered-copper bonding material is applied to the terminal end portions, and then, heating is performed in hydrogen at a temperature of 350 °C for 5 minutes, whereby the terminal end portions can be fixed. Alternatively, the terminal end portions of the first thermal conductor 1 and the second thermal conductor 2 after having been rolled up may be fixed by laser welding, resistance welding, solder bonding, resin bonding, or the like.

Finally, the first thermal conductor 1 and the second thermal conductor 2 rolled up around the core material 4 are cut to a thickness of about 1 mm, for example, by an electric discharge machining wire, a diamond cutter, or the like, whereby the stress relaxation structure 10 with the rolled-up body 3 shown in FIGS. 1 and 2 can be obtained.

### [Thermoelectric conversion module]

Next, an embodiment of the thermoelectric conversion module of the present invention will be described in detail with reference to the drawings.

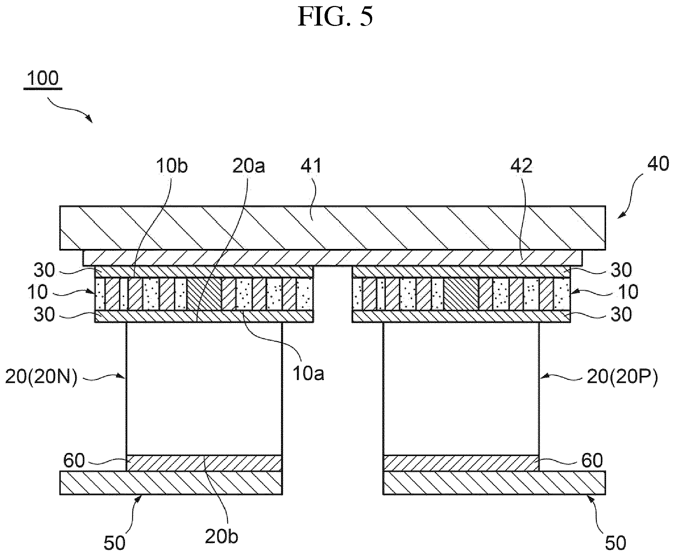

FIG. 5 is a schematic cross-sectional view of a thermoelectric conversion module 100 in this embodiment. The thermoelectric conversion module 100 in this embodiment is characterized by having the aforementioned stress relaxation structure 10 and a thermoelectric conversion element 20 bonded thereto. In the thermoelectric conversion module 100 in this embodiment, the stress relaxation structure 10 and the thermoelectric conversion element 20 are bonded together via a metal layer 30. As a material of the metal layer 30, a low-temperature-sintering metal paste material containing copper oxide can be used, for example. It should be noted that the stress relaxation structure 10 and the thermoelectric conversion element 20 may also be bonded together with a brazing filler metal.

The thermoelectric conversion module 100 in this embodiment includes two types of thermoelectric conversion elements 20 that are a P-type thermoelectric conversion element 20P and an N-type thermoelectric conversion element 20N. Each thermoelectric conversion element 20 is an element that generates current based on the temperature difference between the pair of end faces 20a and 20b. The P-type thermoelectric conversion element 20P is a silicon-germanium element, for example, and flows current from the high temperature side to the low temperature side. The N-type thermoelectric conversion element 20N is a silicon-magnesium element, for example, and flows current from the low temperature side to the high temperature side.

The coefficient of linear expansion of the silicon-germanium element that is the P-type thermoelectric conversion element 20P is about 3.5 ppm/°C, for example. The coefficient of linear expansion of the silicon-magnesium element that is the N-type thermoelectric conversion element 20N is about 15.5 ppm/°C, for example.

The thermoelectric conversion module 100 in this embodiment further includes a wiring substrate 40 bonded to the stress relaxation structure 10 and a copper electrode 50 bonded to the thermoelectric conversion element 20.

The wiring substrate 40 has a ceramic substrate 41 of aluminum nitride or the like, for example, and a copper wire 42 formed on the surface thereof and is bonded to an end face 10b of the stress relaxation structure 10 on the opposite side of an end face 10a to which the thermoelectric conversion element 20 is bonded, in the roll-up axis direction of the rolled-up body 3 of the thermoelectric conversion module 100. In the thermoelectric conversion module 100 in this embodiment, the stress relaxation structure 10 and the wiring substrate 40 are bonded together via a metal layer 30. As a material of the metal layer 30, a low-temperature-sintering metal paste material containing copper oxide can be used, for example.

The copper electrode 50 is solder-bonded to the end face 20b of the thermoelectric conversion element 20 on the opposite side of the end face 20a to which the stress relaxation structure 10 is bonded, using a sheet-like Sn-3.5Ag-1.5Cu alloy. That is, the copper electrode 50 is bonded to the end face 20b of the thermoelectric conversion element 20 via a solder layer 60. The reflow temperature of the solder bonding is about 270 °C, for example.

It should be noted that the thermoelectric conversion module 100 may have a sealing layer that is formed by a sealing technology using a glass material or a resin material for sealing the thermoelectric conversion module 100. As the resin material used for the sealing layer, epoxy resin, polyamide imide, polyimide, silicon resin, or the like can be used, for example. In addition, as the glass material used for the sealing layer, low-melting vanadium glass or the like can be used. Further, forming a sealing layer for sealing the bonded portion using vacuum sealing or an inert sealing technology can increase the reliability of the bonded portion.

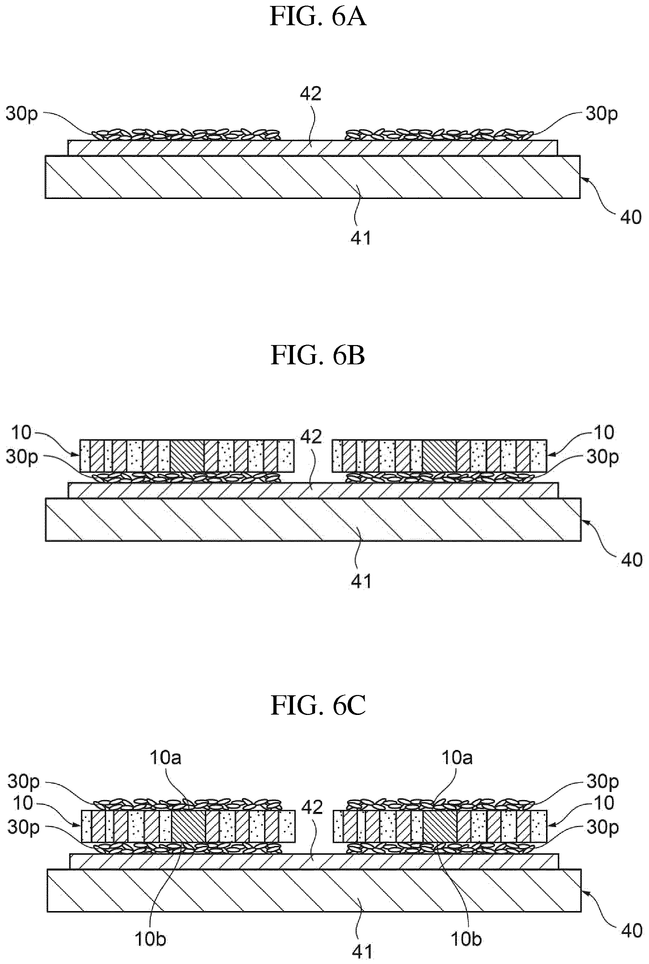

Hereinafter, an example of a method for producing the thermoelectric conversion module 100 in this embodiment will be described. FIGS. 6A to 6F are schematic cross-sectional views each illustrating a step of the method for producing the thermoelectric conversion module 100.

In order to produce the thermoelectric conversion module 100, a paste 30p of a low-temperature-sintering metal material is applied onto a region, which corresponds to the installation position of the thermoelectric conversion element 20, of the copper wire 42 of the wiring substrate 40. Alternatively, such a region can be covered with a low-temperature-sintering metal material by plating or the like.

The low-temperature-sintering metal material contains one of metal particles, metal oxide particles, or metal salt particles. As the metal particles, for example, it is possible to use one type of metal selected from silver, copper, gold, platinum, palladium, rhodium, osmium, ruthenium, iridium, iron, tin, zinc, cobalt, nickel, chromium, titanium, tantalum, tungsten, indium, silicon, aluminum, or the like; or an alloy containing two or more types of such metal. As the oxide particles, gold oxide, silver(I) oxide, silver(II) oxide, or copper(II) oxide can be used. As the metal salt particles, silver acetate, silver neodecanoate, or the like can be used as a metal carboxylate.

When the low-temperature-sintering metal material contains silver or copper particles, it is preferable to use particles with an average particle diameter of greater than 1 nm and less than or equal to 100 µm. In addition, in order to avoid agglomeration of particles, it is preferable to coat such particles with an organic dispersant. As the dispersant, an alkylcarboxylic acid or alkylamine can be used.

When the low-temperature-sintering metal material contains silver oxide particles, a reducing agent made of an organic substance and a solvent are also contained in addition to the silver oxide particles. When the low-temperature-sintering metal material contains copper oxide particles, a solvent for a paste is also contained in addition to the copper oxide particles. The average particle diameter of the metal oxide particles contained in the low-temperature-sintering metal material is preferably greater than or equal to 1 nm and less than or equal to 50 µm. The content of the metal oxide particles in the total parts by mass of the low-temperature-sintering metal material is preferably greater than 50 parts by mass and less than or equal to 99 parts by mass. As the metal content in the low-temperature-sintering metal material is higher, the amount of residue of the organic substance after bonding at a low temperature can be smaller, and a dense baked layer can thus be formed at a low temperature, and further, metallic bonds can be formed at the bonding interface. Consequently, the bonding strength is increased, and further, a metal layer with a high heat radiation property and high heat resistance can be formed. It should be noted that when the metal content in the low-temperature-sintering metal material is over 99 parts by mass, an organic substance that is needed for reduction runs short, and reduction sintering cannot be performed.

As the reducing agent made of an organic substance contained in the low-temperature sintering-metal material, one of alcohols, carboxylic acids, or amines is preferably used, for example. Among them, alcohols with low environmental burdens are preferably used. As a compound containing an available alcohol group, alkyl alcohol can be used. Examples include heptyl alcohol, octyl alcohol, nonyl alcohol, decyl alcohol, undecyl alcohol, dodecyl alcohol, tridecyl alcohol, tetradecyl alcohol, pentadecyl alcohol, hexadecyl alcohol, heptadecyl alcohol, octadecyl alcohol, nonadecyl alcohol, and eicosyl alcohol. Further, not only primary alcohols, but also secondary alcohols, tertiary alcohols, alkane diol, or an alcohol compound with a cyclic structure can be used. Besides, a compound with a number of alcohol groups, such as ethylene glycol or triethylene glycol, can also be used.

The content of the reducing agent contained in the low-temperature-sintering metal material is preferably in the range of 1 to 50 parts by mass relative to the total mass of the silver oxide particles. This is because the amount of the reducing agent that is less than 1 part by mass is not sufficient to produce metal particles by reducing a metal particle precursor in the bonding material. Meanwhile, if the amount of the reducing agent is over 50 parts by mass, the amount of residue after bonding is increased. Consequently, it becomes difficult to achieve metal bonding at the interface and densification in the bonded silver layer. In the bonding material, metal particles with relatively large particles, specifically, an average particle diameter of about 50 µm to 100 µm can also be mixed and used. This is because metal particles with an average particle diameter of less than or equal to 100 nm that are produced during bonding serve the function of sintering the metal particles with an average particle diameter of about 50 µm to 100 µm together. In addition, it is also possible to mix metal particles with a particle diameter of less than or equal to 100 nm in advance.

When a low-temperature-sintering metal material is used as the paste 30p, a solvent may be added to the low-temperature-sintering metal material. As the solvent, alcohols can be used, for example. Examples of alcohols that can be used as the solvent include heptyl alcohol, octyl alcohol, nonyl alcohol, decyl alcohol, undecyl alcohol, dodecyl alcohol, tridecyl alcohol, tetradecyl alcohol, pentadecyl alcohol, hexadecyl alcohol, heptadecyl alcohol, octadecyl alcohol, nonadecyl alcohol, and eicosyl alcohol. Alternatively, glycols such as diethylene glycol, ethylene glycol, triethylene glycol, diethylene glycol monobutyl ether, diethylene glycol monohexyl ether, and diethylene glycol diethyl ether can also be used. Further, not only primary alcohols, but also secondary alcohols, tertiary alcohols, alkane diol, or an alcohol compound with a cyclic structure can be used. Besides, terpineol, ethylene glycol, ethylene glycol, or triethylene glycol can be used. Among them, a glycol-based solvent is preferably used. This is because glycol-based solvents are inexpensive and have low toxicity to human bodies and the like. Further, as such an alcohol-based solvent functions not only as a solvent but also as a reducing agent for silver oxide, such a solvent can be used as a reducing agent by being adjusted to have an appropriate amount relative to the amount of silver oxide particles. As a solvent for a paste, a solvent with a boiling point of less than or equal to 350 °C can be used as in the case where silver particles or copper particles are used. When a low-temperature-sintering metal material containing silver oxide particles is used in a paste form, a solvent with a boiling point of less than or equal to 350 °C can be used.

Next, as shown in FIG. 6B, the stress relaxation structure 10 is disposed on a region, which corresponds to the installation position of the thermoelectric conversion element 20, of the wiring substrate 40 via the paste 30p of the low-temperature-sintering metal material.

Next, as shown in FIG. 6C, a paste 30p of a low-temperature-sintering metal material is applied to the end face 10a of the stress relaxation structure 10 on the opposite side of the end face 10b that is opposite the wiring substrate 40.

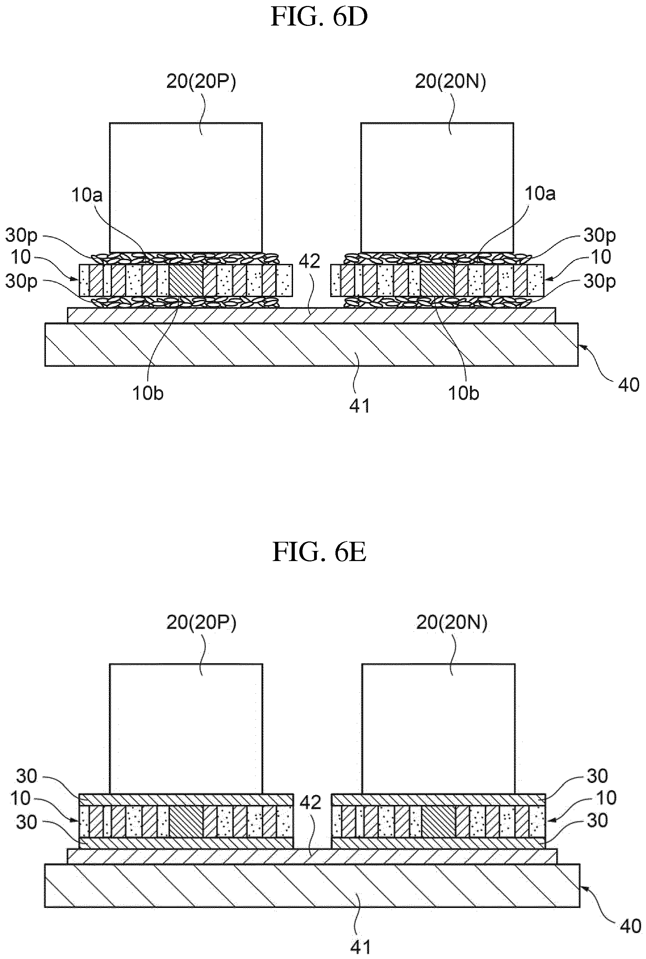

Next, as shown in FIG. 6D, the thermoelectric conversion element 20 is disposed on the end face 10a of the stress relaxation structure 10 on the opposite side of the end face 10b that is opposite the wiring substrate 40, via the paste 30p of the low-temperature-sintering metal material. Then, heating is performed at about 350 °C in a hydrogen atmosphere, for example, and a pressure of 1.0 MPa is applied to the wiring substrate 40, the stress relaxation structure 10, and the thermoelectric conversion elements 20 in the stacked direction thereof. Accordingly, the paste 30p of the low-temperature-sintering metal material is sintered, and as shown in FIG. 6E, the wiring substrate 40 and the stress relaxation structure 10 are bonded together via the metal layer 30, while the stress relaxation structure 10 and the thermoelectric conversion element 20 are bonded together via the metal layer 30.

It should be noted that when the low-temperature-sintering metal material contains silver particles or silver oxide particles, the paste 30p of the low-temperature-sintering metal material can be sintered in any of the air, nitrogen, or a reducing atmosphere. Meanwhile, when the low-temperature-sintering metal material contains copper particles or copper oxide particles, the low-temperature-sintering metal material should be sintered in a reducing atmosphere such as hydrogen or formic acid. This is because in order to perform bonding by reducing copper particles or copper oxide particles, a reducing atmosphere should be used.

In addition, a pressure applied to the wiring substrate 40, the stress relaxation structure 10, and the thermoelectric conversion element 20 in the stacked direction thereof while the paste 30p of the low-temperature-sintering metal material is sintered can be set greater than 0 MPa and less than or equal to 30 MPa. Applying a pressure can densify the metal layers 30 and increase the reliability of the bonding layers. However, when the pressure is over 30 MPa, there is a possibility that the thermoelectric conversion element 20 may become damaged. The sintering time can be set longer than 1 second and shorter than 180 minutes.

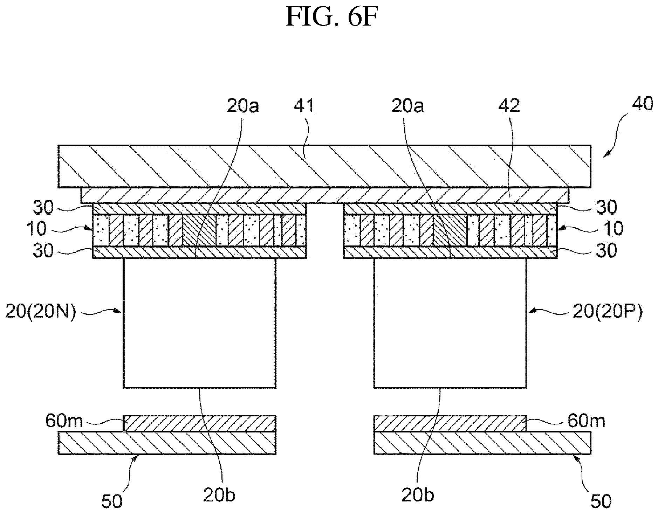

Finally, as shown in FIG. 6F, a copper electrode 50 is solder-bonded to the end face 20b of the thermoelectric conversion element 20 on the opposite side of the end face 20a to which the stress relaxation structure 10 is bonded, using a sheet-like Sn-3.5Ag-1.5Cu alloy 60m, for example. Accordingly, the copper electrode 50 is bonded to the end face 20b of the thermoelectric conversion element 20 via the solder layer 60. The reflow temperature of the solder bonding is about 270 °C, for example. Accordingly, the thermoelectric conversion module 100 shown in FIG. 5 can be produced.

Hereinafter, the functions of the stress relaxation structure 10 and the thermoelectric conversion module 100 using the same in this embodiment will be described.

The thermoelectric conversion module 100 in this embodiment is used with the wiring substrate 40 side located on the high temperature side and with the copper electrode 50 side located on the low temperature side, for example. More specifically, the wiring substrate 40 is attached to a high temperature body that is a heat generation source, such as an exhaust pipe of an automobile or the like, in a thermally conductive manner, and the copper electrode 50 side is cooled by air cooling or water cooling.

Accordingly, in the thermoelectric conversion module 100, the temperature of the wiring substrate 40 on the high temperature side is increased to about 500 °C, for example, while the cooled copper electrode 50 becomes the low temperature side, whereby a temperature difference is generated between the wiring substrate 40 side and the copper electrode 50 side of the thermoelectric conversion element 20. Due to such temperature difference, the P-type thermoelectric conversion element 20P flows current from the high temperature side to the low temperature side, and the N-type thermoelectric conversion element 20N flows current from the low temperature side to the high temperature side, thereby generating an electromotive force, so that the thermoelectric conversion module 100 can generate electricity.

However, the linear expansion coefficient of the silicon-germanium element that is the P-type thermoelectric conversion element 20P differs from that of the silicon-magnesium element that is the N-type thermoelectric conversion element 20N. Therefore, when the stress relaxation structures 10 are not provided, there is a possibility that strains may occur due to a pressure generated by the difference in the amount of thermal expansion between the thermoelectric conversion elements 20 and the wiring substrate 40 due to a heat cycle while the thermoelectric conversion module 100 generates electricity or due to the heat generated during the production of the thermoelectric conversion module 100, so that the bonded portions between the thermoelectric conversion elements 20 and the wiring substrate 40 may break or the thermoelectric conversion elements 20 may break.

In contrast, the thermoelectric conversion module 100 in this embodiment includes the stress relaxation structure 10 and the thermoelectric conversion element 20 bonded thereto. In addition, each stress relaxation structure 10 in this embodiment has a rolled-up body 3 obtained by alternately rolling up the first thermal conductor 1 and the second thermal conductor 2. The first thermal conductor 1 is metal foil and the second thermal conductor 2 is porous metal foil.

Thus, heat on the high temperature side can be efficiently transferred to each thermoelectric conversion element 20 by the metal foil and the porous metal foil, which have high thermal conductivity, of the rolled-up body 3 that constitutes the stress relaxation structure 10. Further, the rolled-up body 3 of the stress relaxation structure 10 can tolerate, with the porous metal foil that will easily deform in comparison with the metal foil, thermal expansion of the thermoelectric conversion element 20, and thus can relax a thermal stress that acts between the thermoelectric conversion element 20 and the wiring substrate 40 on the high temperature side.

In addition, as the second thermal conductor 2 is porous metal foil, a bonding property with respect to the wiring substrate 40 and the thermoelectric conversion element 20 is excellent in comparison with when a carbon-based sheet material is used, for example. Thus, the bonding reliability between the rolled-up body 3 of the stress relaxation structure 10, the wiring substrate 40, and the thermoelectric conversion element 20 is increased. Thus, using the stress relaxation structure 10 in this embodiment can increase the vibration durability of the thermoelectric conversion module 100.

In addition, in the stress relaxation structure 10 in this embodiment, both the first thermal conductor 1 that is metal foil and the second thermal conductor 2 that is porous metal foil are exposed at the end faces of the rolled-up body 3 in the roll-up axis direction, that is, the core material 4 in the axis direction. Thus, the stress relaxation structure 10 can be surely and easily bonded to the wiring substrate 40 and to the thermoelectric conversion element 20, and the bonding reliability can thus be increased.

In addition, in the stress relaxation structure 10 in this embodiment, when each of the materials of the metal foil that is the first thermal conductor 1 and the porous metal foil that is the second thermal conductor 2 constituting the rolled-up body 3 is copper or nickel, the thermal conductivity and the bonding reliability of the stress relaxation structure 10 can be further increased.

In addition, in the stress relaxation structure 10 in this embodiment, the rolled-up body 3 has the core material 4, and the first thermal conductor 1 and the second thermal conductor 2 are integrally rolled up around the core material 4. Accordingly, the rolled-up body 3 can be easily rolled up and the stress relaxation structure 10 can thus be easily produced. In addition, when the core material 4 has a plate shape, the rolled-up body 3 with approximately rectangular end faces is formed. As an element on which the stress relaxation structure 10 is disposed also has a plate shape, a wasted region can be reduced, which in turn can increase the packaging density of the element.

In addition, in the thermoelectric conversion module 100 in this embodiment, the stress relaxation structure 10 and the thermoelectric conversion element 20 are bonded together via the metal layer 30. As the metal layer 30 has high heat resistance, the bonding reliability between the wiring substrate 40 on the high temperature side that is close to a heat source and the thermoelectric conversion element 20 can be increased. In addition, the metal layer 30 is firmly bonded to the metal foil that is the first thermal conductor 1 and the porous metal foil that is the second thermal conductor 2 constituting the rolled-up body 3 of the stress relaxation structure 10, and the stress relaxation structure 10 can thus be firmly bonded to the wiring substrate 40 and the thermoelectric conversion element 20. Thus, the bonding reliability between the stress relaxation structure 10, the wiring substrate 40, and the thermoelectric conversion element 20 can be increased, and the vibration durability of the thermoelectric conversion module 100 can thus be increased.

As described above, according to this embodiment of the present invention, both high thermal conductivity and high thermal stress relaxation ability can be achieved, and the stress relaxation structure 10 with excellent vibration durability as well as the thermoelectric conversion module 100 with such a stress relaxation structure 10 can be provided.

### [Insulating substrate]

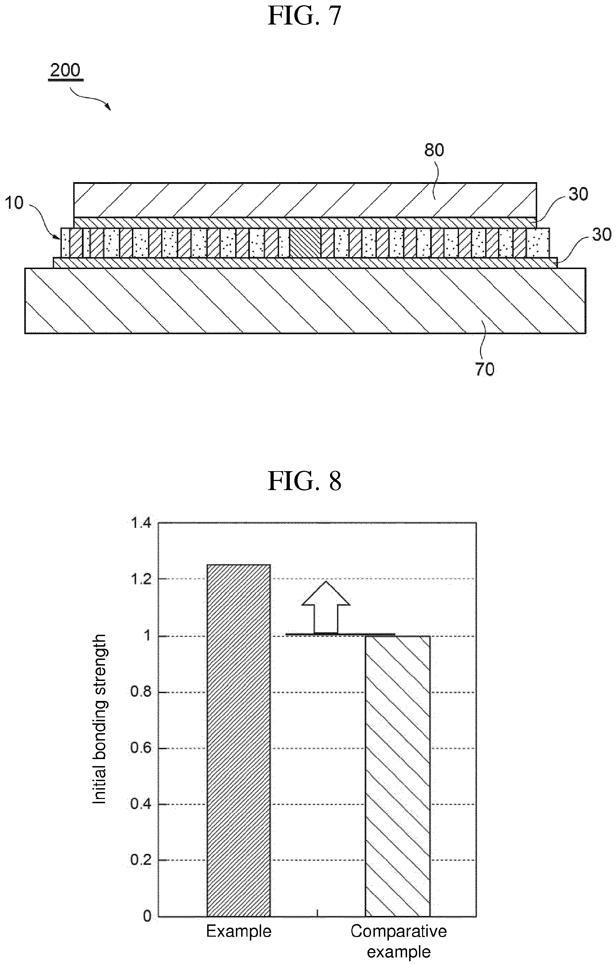

The stress relaxation structure 10 in this embodiment can also be used as an insulating substrate for a thermoelectric conversion module. FIG. 7 is a schematic cross-sectional view of an insulating substrate 200 that uses the stress relaxation structure 10 in this embodiment. The insulating substrate 200 includes a ceramic substrate 70 with a surface plated with Ni, the stress relaxation structure 10 bonded to the surface of the ceramic substrate 70 via a metal layer 30, and a copper wire 80 bonded to the stress relaxation structure 10 via a metal layer 30.

The ceramic substrate 70 is a thin, 100 mm × 100 mm square plate of silicon nitride with a thickness of 0.6 mm, for example. The thickness of the copper wire 80 is 0.4 mm, for example. The metal layer 30 can be formed by, for example, using a copper paste, which has been obtained by dispersing copper particles with an average particle diameter of 1 µm in triethylene glycol, as a low-temperature-sintering metal material, applying the copper paste to a portion where the metal layer 30 is to be formed, and heating and baking the paste in a hydrogen atmosphere at 400 °C for 15 minutes. After the metal layer 30 is baked, a redundant portion of the peripheral portion may be cut off with an electric discharge machining wire.

As the insulating substrate 200 shown in FIG. 7 is used at a portion close to a heat source, high reliability is required even at a high temperature. Thus, using the aforementioned stress relaxation structure 10 can achieve both high thermal conductivity and high thermal stress relaxation ability, and obtain the insulating substrate 200 with high vibration durability and high reliability. Such an insulating substrate 200 can be favorably used in the field of power modules and the like where an increase in the operating temperature has been advanced.

Although the embodiments of the present invention have been described in detail with reference to the drawings, specific configurations are not limited thereto, and any design changes and the like within the scope of the present invention.

Hereinafter, a stress relaxation structure in accordance with an example of the present invention and a stress relaxation structure in accordance with a comparative example, as a comparison target, will be described.

### [Example]

As the metal foil of the first thermal conductor, copper foil produced by Nilaco Corporation (product number: CU-113213) with a thickness of 0.020 mm, a width of 100 mm, and a length of 300 mm was prepared. Then, a porous film with a thickness of 5 µm was formed on the surface of the prepared copper foil using electroless copper plating described on pages 66-69 of the Journal of The Japan Institute of Electronics Packaging, Vol. 1 (1998), No. 1, whereby porous metal foil that is the second thermal conductor was bonded to the metal foil of the first thermal conductor.

Next, a columnar copper bar produced by Nilaco Corporation (product number: CU-112544) with a diameter of 2.0 mm was prepared as a core material, and an end of each of the first thermal conductor and the second thermal conductor in the longitudinal direction was fixed to the prepared core material using laser welding. Then, the first thermal conductor and the second thermal conductor were rolled up around the core material, and a copper oxide paste, which is a low-temperature-sintering metal material, was applied to the terminal end portions in the longitudinal direction, and then, the paste was heated in a hydrogen atmosphere at 350 °C for 5 minutes, whereby the terminal end portions in the longitudinal direction were fixed. The outside diameter of the rolled-up first and second thermal conductors was about 5 mm.

Finally, the first and second thermal conductors rolled up around the core material were cut with an electric discharge machining wire to obtain a rolled-up body with a thickness of about 1 mm, whereby a stress relaxation structure of an example was obtained. The obtained stress relaxation structure has a rolled-up body in which the first and second thermal conductors are alternately rolled up, and the first thermal conductor is metal foil, while the second thermal conductor is porous metal foil. In addition, the first and second thermal conductors are bonded together.

Next, a bonding strength test was conducted on the stress relaxation structure. First, two disk-shaped copper plates each having a diameter of 10 mm and a thickness of 5 mm were prepared. Then, a copper oxide paste, which is a low-temperature-sintering metal material, was applied to each of one end face and the other end face of the rolled-up body in the roll-up axis direction of the stress relaxation structure, and the prepared copper plates were placed on the respective end faces of the rolled-up body. After that, a pressure of 1.0 MPa was applied to the copper plates and the stress relaxation structure in the stacked direction thereof under a hydrogen atmosphere, and heating was performed at 350 °C for 5 minutes, whereby the copper plates were bonded to the respective end faces of the rolled-up body in the roll-up axis direction of the stress relaxation structure via metal layers, and a test piece was thus obtained.

Next, a shearing stress was applied to the obtained test piece at a shear rate of 30 mm/minute using bond tester SS-100KP, which is a shearing tester with a maximum load of 100 kg produced by SEISHIN TRADING CO., LTD, and the maximum load upon fracture was measured. Then, the measured maximum load was divided by the bonded area to determine the bonding strength.

### [Comparative example]

A carbon sheet was used as the second thermal conductor that constitutes the rolled-up body, and a stress relaxation structure of a comparative example was produced in the same way as the stress relaxation structure of the aforementioned example except that the first and second thermal conductors were stacked without being bonded to each other. For the carbon sheet, a sheet with a thickness of 0.020 mm, a width of 100 mm, and a length of 300 mm was used. Then, a test piece was produced in the same way as the stress relaxation structure of the example, and the maximum load upon fracture was measured with a shearing tester. Then, the measured maximum load was divided by the bonded area to determine the bonding strength.

FIG. 8 is a graph showing the relationship between the initial bonding strength of the stress relaxation structure of the example and that of the comparative example. As shown in FIG. 8, provided that the initial bonding strength of the stress relaxation structure of the comparative example is 1, the initial bonding strength of the stress relaxation structure of the example is greater than or equal to 1.2. Herein, the initial bonding strength of the stress relaxation structure of the comparative example was 10 MPa and that of the example was 12 MPa.

With regard to the rolled-up body of the stress relaxation structure used for the test piece of the example, porous metal foil was used for the second thermal conductor. Therefore, at the end faces of the rolled-up body in the roll-up axis direction, not only the exposed portions of the metal foil of the first thermal conductor but also the exposed portions of the porous metal foil were bonded to the copper plates by the metal layers, whereby the bonding strength was increased.

In contrast, with regard to the rolled-up body of the stress relaxation structure used for the test piece of the comparative example, a carbon sheet was used for the second thermal conductor. Therefore, the exposed portions of the carbon sheet were not bonded to the copper plates by the metal layers at the end faces of the rolled-up body in the rolled-up axis direction, whereby the bonding strength was decreased.

Accordingly, it was confirmed that the stress relaxation structure in accordance with the example of the present invention has a more excellent bonding property with respect to a metal member as well as more excellent vibration durability than the stress relaxation structure in accordance with the comparative example.

### Reference Signs List

- 1: First thermal conductor
- 2: Second thermal conductor
- 3: Rolled-up body
- 4: Core material
- 10: Stress relaxation structure
- 20: Thermoelectric conversion element
- 30: Metal layer
- 100: Thermoelectric conversion module

## Claims

1. A thermoelectric conversion module (100) **characterized by** comprising
a stress relaxation structure (10) with a rolled-up body (3), the rolled-up body (3) having a first thermal conductor (1) and a second thermal conductor (2) that are alternately rolled up, wherein the first thermal conductor (1) is metal foil, and the second thermal conductor (2) is porous metal foil; and
a thermoelectric conversion element (20) bonded to the stress relaxation structure (10).

2. The thermoelectric conversion module (100) according to claim 1, wherein each of materials of the metal foil and the porous metal foil of the stress relaxation structure (10) is one of copper or nickel.

3. The thermoelectric conversion module (100) according to claim 1 or 2, wherein the rolled-up body (3) of the stress relaxation structure (10) has a core material (4), and the first thermal conductor (1) and the second thermal conductor (2) are alternately rolled up around the core material (4).

4. The thermoelectric conversion module (100) according to claim 3, wherein the core material (4) of the stress relaxation structure (10) has a plate shape.

5. The thermoelectric conversion module (100) according to claim 1, wherein the first thermal conductor (1) and the second thermal conductor (2) of the stress relaxation structure (10) are bonded together.

6. The thermoelectric conversion module (100) according to claim 1, wherein both the metal foil and the porous metal foil of the stress relaxation structure (10) are exposed at end faces of the rolled-up body (3) in a roll-up axis direction.

7. The thermoelectric conversion module (100) according to claim 1, wherein the second thermal conductor (2) of the stress relaxation structure (10) is a porous film formed on a surface of the first thermal conductor (1).

8. The thermoelectric conversion module (100) according to claim 1, wherein the stress relaxation structure (10) and the thermoelectric conversion element (20) are bonded together via a metal layer (30).

## Patentansprüche

1. Thermoelektrisches Umsetzmodul (100), **gekennzeichnet durch**:
eine Belastungsentspannungsstruktur (10) mit einem zusammengerollten Körper (3), wobei der zusammengerollte Körper (3) einen ersten Wärmeleiter (1) und einen zweiten Wärmeleiter (2) besitzt, die abwechselnd zusammengerollt werden, wobei der erste Wärmeleiter (1) eine Metallfolie ist und der zweite Wärmeleiter (2) eine poröse Metallfolie ist; und
ein thermoelektrisches Umsetzelement (20), das mit der Belastungsentspannungsstruktur (10) verbunden ist.

2. Thermoelektrisches Umsetzmodul (100) nach Anspruch 1, wobei jedes der Materialien der Metallfolie und der porösen Metallfolie der Belastungsentspannungsstruktur (10) entweder Kupfer oder Nickel ist.

3. Thermoelektrisches Umsetzmodul (100) nach Anspruch 1 oder 2, wobei der zusammengerollte Körper (3) der Belastungsentspannungsstruktur (10) ein Kernmaterial (4) besitzt und der erste Wärmeleiter (1) und der zweite Wärmeleiter (2) abwechselnd um das Kernmaterial (4) zusammengerollt werden.

4. Thermoelektrisches Umsetzmodul (100) nach Anspruch 3, wobei das Kernmaterial (4) der Belastungsentspannungsstruktur (10) eine Plattenform besitzt.

5. Thermoelektrisches Umsetzmodul (100) nach Anspruch 1, wobei der erste Wärmeleiter (1) und der zweite Wärmeleiter (2) der Belastungsentspannungsstruktur (10) miteinander verbunden sind.

6. Thermoelektrisches Umsetzmodul (100) nach Anspruch 1, wobei die Metallfolie und die poröse Metallfolie der Belastungsentspannungsstruktur (10) an Stirnseiten des zusammengerollten Körpers (3) in einer Zusammenrollachsenrichtung freiliegen.

7. Thermoelektrisches Umsetzmodul (100) nach Anspruch 1, wobei der zweite Wärmeleiter (2) der Belastungsentspannungsstruktur (10) ein poröser Film ist, der auf einer Oberfläche des ersten Wärmeleiters (1) ausgebildet ist.

8. Thermoelektrisches Umsetzmodul (100) nach Anspruch 1, wobei die Belastungsentspannungsstruktur (10) und das thermoelektrische Umsetzelement (20) durch eine Metallschicht (30) miteinander verbunden sind.

## Revendications

1. Module de conversion thermoélectrique (100) **caractérisé en ce qu'**il comprend
une structure de relaxation de contraintes (10) avec un corps enroulé (3), le corps enroulé (3) ayant un premier conducteur thermique (1) et un second conducteur thermique (2) qui sont alternativement enroulés, dans lesquels le premier conducteur thermique (1) est une feuille de métal, et le second conducteur thermique (2) est une feuille en métal poreux ; et
un élément de conversion thermoélectrique (20) collé à la structure de relaxation de contraintes (10).

2. Module de conversion thermoélectrique (100) selon la revendication 1, dans lequel chacun des matériaux de la feuille de métal et de la feuille en métal poreux de la structure de relaxation de contraintes (10) est choisi parmi du cuivre ou du nickel.

3. Module de conversion thermoélectrique (100) selon la revendication 1 ou 2, dans lequel le corps enroulé (3) de la structure de relaxation de contraintes (10) comprend un matériau d'âme (4), et le premier conducteur thermique (1) et le second conducteur thermique (2) sont alternativement enroulés autour du matériau d'âme (4).

4. Module de conversion thermoélectrique (100) selon la revendication 3, dans lequel le matériau d'âme (4) de la structure de relaxation de contraintes (10) a une forme en plaque.

5. Module de conversion thermoélectrique (100) selon la revendication 1, dans lequel le premier conducteur thermique (1) et le second conducteur thermique (2) de la structure de relaxation de contraintes (10) sont collés ensemble.

6. Module de conversion thermoélectrique (100) selon la revendication 1, dans lequel à la fois la feuille de métal et la feuille en métal poreux de la structure de relaxation de contraintes (10) sont exposées au niveau des faces terminales du corps enroulé (3) dans une direction de l'axe d'enroulement.

7. Module de conversion thermoélectrique (100) selon la revendication 1, dans lequel le second conducteur thermique (2) de la structure de relaxation de contraintes (10) est un film poreux formé sur une surface du premier conducteur thermique (1).

8. Module de conversion thermoélectrique (100) selon la revendication 1, dans lequel la structure de relaxation de contraintes (10) et l'élément de conversion thermoélectrique (20) sont collés ensemble via une couche en métal (30).
